# EUROPEAN PATENT APPLICATION

(11) **EP 1 443 810 A1**
(43) Date of publication of application: **04.08.2004**
(21) Application number: 03001494.8
(22) Date of filing: 23.01.2003
(51) Int. Cl.: H05K 3/42

(54) **Multilayer backplane with vias for pin connection**

(71) Applicant: ALCATEL, 75008 Paris (FR)
(72) Inventor: Hoffmann, Hans, 74348 Lauffen (DE)
(74) Representative: Urlichs, Stefan, Dipl.-Phys.

(57) **Abstract**

A multi-layer circuit board has blind holes (42, 43), which are coated with a metal layer (13) and with a conducting finish protection (12). The blind hole is first drilled as a through-hole (14) through a pre-fitted sub-set of circuit board layers (10, 10') and coated before the remaining layers (21, 22) of the board are fitted together by thermo-compression. An outer layer (22) buries the hole (14) during further processing steps and is only opened after such further processing steps are finished. The metal coating (13) does thus not extend to the surface but only through the sub-set (10, 10') of circuit board layers. The blind-hole (43) thus created is suitable for inserting press-fit connectors (44).

## Description

### Field of the Invention

The present invention relates to the field of printed circuit boards and more particularly to multi-layer printed circuit boards for use as a back-plane or as a mid-plane in a telecommunications network element.

### Background of the Invention

Multi-layer printed circuit boards are composed of a number of individually structured circuit board layers, which are glued together under high pressure and temperature using intermediate sheets of melting organic material such as epoxy or the like. Those intermediate sheets are known as prepregs. The resulting layers stack must then be trough-connected. This is achieved by drilling holes at predefined contact positions through the layer stack and depositing a copper layer in the hole. Finally, it is important to apply a finish protection, i.e. a conducting layer that protects the copper against corrosion and pollution. Different material systems are used as finish protection such as chemical NiAu, chemical Sn or OSP.

Printed circuit boards that are to be used as back-planes (often also referred to as mother boards) need to have connectors for daughter boards. Two types of connectors are known: a first surface mounted type (SMD) which is soldered to corresponding pads on the circuit board or connectors which pins or stubs are pressed into corresponding holes in the board. Like through-connections, these holes are copper coated through holes.

In order to use surface space more efficiently, build more compact devices, and reduce signal path lengths for high frequency applications, some back-planes have connectors for daughter boards on both surface sides. Such back-planes are commonly also referred to as mid-planes. From US 4,686,607, a daughter board/back-plane assembly is known, which has connectors on both surface sides. The connectors are fitted from both sides into corresponding through-holes in the back-plane. However, this implies that the layout of the daughter-board connectors on both sides of the board is mirror-inverted, which is an important drawback in systems with multiple exchangeable plug-in cards.

Another disadvantage of connectors fitted into through-holes is that it degrades high frequency properties of the board as the relatively long copper plated holes extending from one surface to the other act as resonators for high frequency signals. This effect becomes the more prevalent the more layers the boards has and the thicker the board therefore is.

It would therefore be desirable to fit such daughter-board connectors into blind holes (which are sometimes also referred to as blind vias). However, it is particularly difficult to apply a copper plating into blind holes. Because copper deposition is performed chemically or galvanically, deposition inside the blind holes would be insufficient.

The ratio between diameter and thickness of a blind-hole is referred to as aspect ration. Known blind-holes that can be produced today have an aspect ration in the range of 1:1, because otherwise they could not be plated with copper. This aspect ration, however, is to low to allow a firm fit of connectors pressed with their stubs into such blind-holes.

When the blind holes are applied as through-holes through individual layers or pre-fitted sub-sets of layers and copper plated before thermo-pressing the entire layer stack together to form the board, then the copper plating in the blind-holes will suffer during the final etching and plating steps of the outer copper surface and from chemical steps required to manufacture additionally required copper-plated through-holes through the entire layer stack of the board.

Moreover, it is impossible to apply in a final step a finish protection into the blind-holes, but which would be necessary to fulfill certain quality requirements for back-planes.

It is therefore an object of the invention, to provide a multi-layer printed circuit board suitable for high-frequency applications in the range of 1 GHz and more.

Another particular object of the present invention is to provide a method of manufacturing a multi-layer printed circuit board with blind holes plated with copper and finish protection.

### Summary of the Invention

The object is achieved with respect to the circuit board by multi-layer printed circuit according to claim 1 and with respect to the manufacturing method by a method according to claim 4.

In particular, a multi-layer circuit board has blind holes, which are coated with a metal layer and with a conducting finish protection. The blind hole is first drilled as a through-hole through a pre-fitted sub-set of circuit board layers and coated before the remaining layers of the board are fitted together by thermo-compression. An outer layer buries the hole during further processing steps and is only opened after such further processing steps are finished. The metal coating does thus not extend to the surface but only through the sub-set of circuit board layers. The blind-hole thus created is suitable for inserting press-fit connectors.

The invention has the advantage that it uses only well-controllable, standard process steps of circuit board design and that it can be applied to circuit boards with up to hundred layers and even more, which have a total thickness of about 10 mm. Moreover, the invention allows blind-holes with finish protection that have an aspect ration of more than 10:1, preferably of 16:1. Multi-layer circuit boards according to the invention are suitable for high-frequency applications at 2,5 Gbit/s and depending on the size of the board also for 10 Gbit/s applications as they are used in modern telecommunications equipment.

### Brief Description of the Drawings

Preferred embodiments of the present invention will now be described with reference to the accompanying drawings in which
- figure 1: shows a pre-fitted sub-set of layers of the board;
- figure 2: shows thermal pressing of the entire layer stack of the board;
- figure 3: shows the fitted board with an additional copper plated through-hole; and
- figure 4: shows opening of the blind-holes and fitting of a stub of press-fit connector.

### Detailed Description of the Invention

As explained above, it would be highly desirable if connectors could be fitted into blind-holes. However, such blind holes need to have a copper plating and a finish protection. According to a basic idea of the invention, blind holes are made as through holes in a single layer or pre-fitted sub-set of layers. These through-holes are then plated with copper and according to another basic idea of the invention, the final protection is also already applied to this through-hole before the entire layer stack is pressed together.

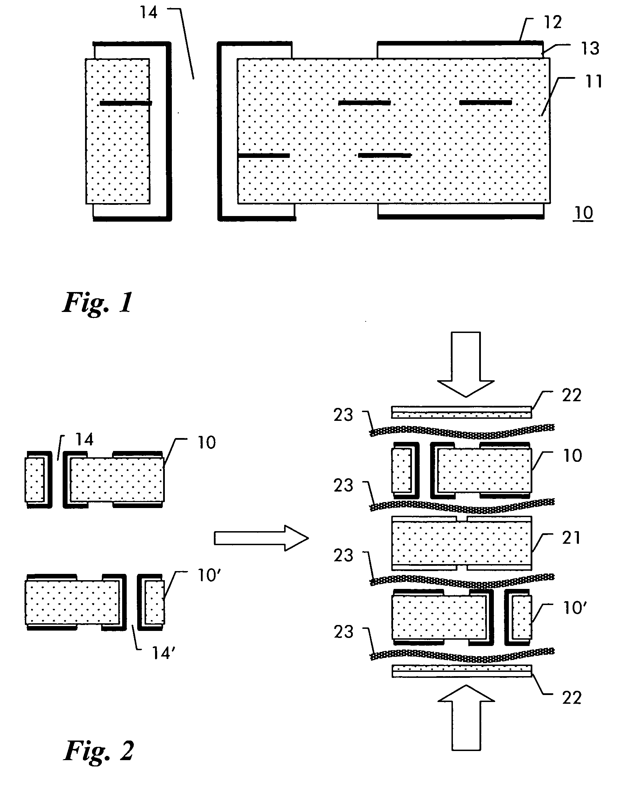

This is shown schematically in figure 1. The figure shows a layer stack 11, which consists in the preferred embodiment of three layers. These layers are structured independently and then glued together with intermediate prepregs in thermal compression step. It is important to understand that this stack is only a sub-set of the layers of the final board, but can also be (if thick enough) a single layer, only. A through-hole 14 is drilled through the stack 11. Then a copper plating 13 is applied to the stack extending also into and through the hole 14. This is achieved by conventional galvanic or chemical deposition. The copper plating is then structured as required. Finally, a finish protection 12, for example chemical NiAu or chemical Sn is applied to the stack over the structured copper plating to protect the copper against corrosion and pollution. The plated layer stack is depicted as 10.

In a next step, the entire set of layers are fitted together. However, in order to contamination of other chemical baths required in further protection steps, according to another basic idea of the invention, a further layer or protecting film (tenting) is applied at least over areas that are plated with the finish protection.

Figure 2 shows this step in more detail. The layer stack 10 and a corresponding layer stack 10' contain the future blind-holes 14, 14'. A further middle layer stack 21 is provided between the two outer stacks 10, 10'. Prepregs 23 are inserted between the layer stacks 10, 21, and 10'. In addition, according to a first embodiment, copper plated outer layers 22 are placed on to and bottom of the entire stack. These additional layers can be for example sheets known as Thermomount, FR4 or a copper foil plus a prepreg with an total layer thickness of approx. 200 µm.

The entire stack is then pressed together (symbolized by two arrows pointing symbolized by block arrows) under high temperature, whereby the prepregs melt and thus glue the individual layers stacks together. As a result, the future blind holes 14, 14' are now buried under the additional outer layers 22.

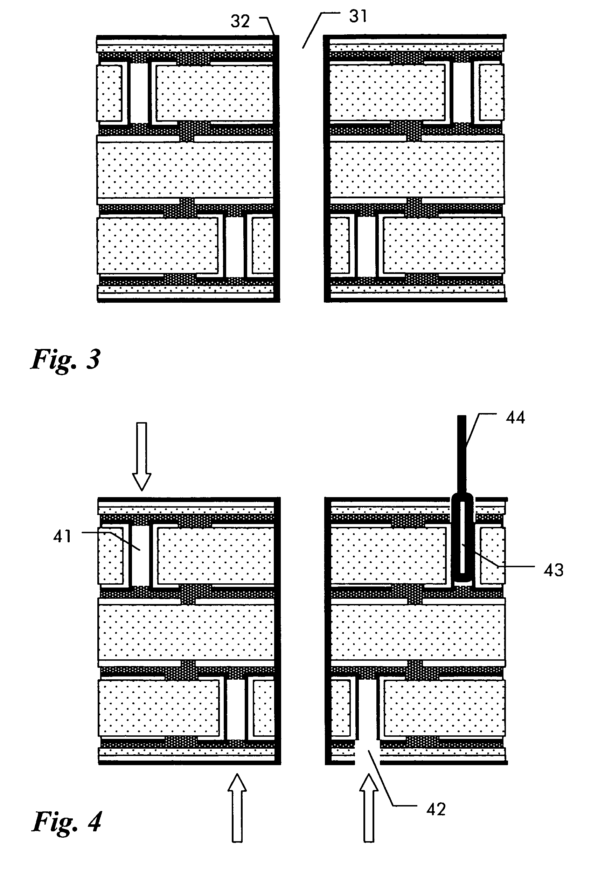

Now the standard process can continue with structuring the outer copper layer, drilling through-holes and plating them with copper and finish protection. This is shown schematically in figure 3. A through hole 31 is drilled in the glued layer stack and copper plating and finish protection 32 are deposited.

In a final step, shown in figure 4, the buried blind-holes 41 forming cavities in the circuit board are opened. Opening can be performed either with a laser or by counter-drilling through the top layers. Blind-hole 42 is shown already opened in the figure.

Press fit connectors with short stubs can now be pressed into the blind-holes thus eliminating the stub capacitance. Figure 4 shows a connector stub 44 pressed into blind-hole 43.

Further modifications of the invention include the following: The blind-holes 14 in figure 1 could be filled with a filling material. Instead of additional outer circuit board layers 22 in figure 2, simple copper foils could then be used to cover the coated blind-holes. The filling in the blind holes could be removed in the final opening step by drilling or using laser power.

In another modification, instead of outer layers 22 in figure 2, only those areas including the blind holes, which are coated with finish protection could be covered with a protection film of varnish. The protection film closes the blind-holes in the same way as the layers 22 in figure 2 and are removed in a final step using laser power.

Other modifications relate to the metal system used as metal coating 13 and to the finish protection in figure 1.

## Claims

1. A multi-layer printed circuit board comprising a number of circuit board layers (10, 21, 22), the circuit board having at least one blind-hole (42, 43), said blind hole extending from a first surface through only part of said circuit board layers (22, 10) and being coated with a metal coating (13) and with a conducting finish protection (12) protecting said metal coating against corrosion and pollution.

2. A circuit board according to claim 1, wherein said metal coating does not extend to said first surface but being applied only in lower circuit layers (10, 10') through which said hole extends.

3. A circuit board according to claim 1, wherein a stub (44) of a press-fit connector being pressed into said blind-hole (43).

4. A method a manufacturing a multi-layer printed circuit board comprising a number of circuit board layers (10, 21, 22), the circuit board having at least one blind-hole (42, 43), said blind hole extending from a first surface through only part of said circuit board layers (22, 10) and being coated with a metal coating (13) and with a conducting finish protection (12) protecting said metal coating against corrosion and pollution, said method comprises the steps of:
drilling a hole though a pre-fitted sub-set of circuit layers and coating the hole with said metal coating (13) and with said conducting finish protection (12); before pressing together said number of circuit board layers.

5. A method according to claim 4, wherein in said step of pressing said number of circuit board layers together, an outer layer is provided over the previously drilled hole, thus protecting the coated hole during further processing steps and wherein in a final processing step, said outer layer is opened over said hole.

6. A method according to claim 4, wherein said previously drilled hole is covered by a protection film during further processing steps and wherein said protection film is opened in a final processing step.
